# EUROPÄISCHE PATENTANMELDUNG

(11) **EP 1 972 954 A1**
(43) Veröffentlichungstag der Anmeldung: **24.09.2008**
(21) Anmeldenummer: 07005664.3
(22) Anmeldetag: 20.03.2007
(51) Int. Cl.: G01R 31/28, E06B 9/68

(54) **Test- und Installationsmodul**

(71) Anmelder: ROTO FRANK AG, 70771 Leinfelden-Echterdingen (DE)
(72) Erfinder: Schroth, Hagen Dipl.-Ing., 72076 Tübingen (DE); Berbesz, Marcin Dipl.-Ing., 73035 Göppingen (DE)
(74) Vertreter: Kohler Schmid Möbus

(57) **Zusammenfassung**

Ein Test- und/oder Installationsmodul (10) für in oder an einem Gebäude zu montierende elektrische Geräte, weist zumindest einen Steckanschluss (17) zum Anschluss einer Verbindungsleitung zu dem elektrischen Gerät und eine Funktionstestauslöseeinrichtung (15) auf. Dadurch wird der Test des elektrischen Geräts erleichtert.

## Beschreibung

Die Erfindung betrifft ein Test- und/oder Installationsmodul für in oder an einem Gebäude zu montierende elektrische Geräte.

In einem Gebäude müssen häufig elektrische Geräte permanent installiert werden. Beispielsweise sind elektrisch öffen- und schließbare Fenster und Türen bekannt, deren Antriebe installiert werden müssen. Fensterantriebe werden in der Regel von Fensterbauern montiert und von Elektroinstallateuren in Betrieb genommen. Vor der Übergabe des Fensterantriebs vom Fensterbauer zum Elektroinstallateur muss der Fensterantrieb durch den Fensterbauer getestet werden. Hierzu muss der Fensterbauer ein vom Fensterantrieb kommendes Kabel mit einem Netzteil verbinden. Für den Test wird dann der Auf - beziehungsweise Zuanschluss mit einer Steuerspannung verbunden. Dabei muss auf die Belegung der einzelnen Adern geachtet werden. Diese Vorgehensweise ist für den Fensterbauer umständlich und überfordert diesen teilweise, da elektrische Installationen nicht zum Kernbereich seines Arbeitsfeldes gehören.

In der DE 10 2005 038 007 A1 wird vorgeschlagen, eine Umsteuereinrichtung eines Elektromotors mit einer Testeinrichtung auszubilden, die den Elektromotor nacheinander in beiden Drehrichtungen betreibt, dabei die Motorbelastung misst und die Drehrichtung mit höherer Belastung als Drehrichtung für die Aufwärtsfahrt festlegt. Diese Vorgehensweise setzt voraus, dass der Elektromotor bereits installiert und an eine Versorgungsspannung in üblicher, im vorhergehenden Absatz beschriebenen Art und Weise, angeschlossen wurde.

Aufgabe der vorliegenden Erfindung ist es, einen Funktionstest eines eingebauten elektrischen Geräts und/oder die Installation eines solchen Geräts zu vereinfachen und die Übergabe des elektrischen Geräts von einem zum anderen Gewerk zu erleichtern.

Diese Aufgabe wird erfindungsgemäß auf einfache und überraschende Art und Weise durch ein Test- und/oder Installationsmodul der eingangs genannten Art gelöst, wobei es zumindest einen Steckanschluss zum Anschluss einer Verbindungsleitung zu dem elektrischen Gerät und eine Funktionstestauslöseeinrichtung aufweist. Ein Steckanschluss hat den Vorteil, dass ein vom elektrischen Gerät kommendes Kabel nicht abisoliert werden muss. Das elektrische Gerät kann dadurch auf besonders einfache Art und Weise mit dem Test - und/oder Installationsmodul verbunden werden. Der Begriff "Steckanschluss" ist dabei weit zu verstehen. Beispielsweise kann der Steckanschluss modulseitig einfach als Anschlussfahnen oder Anschlusspins ausgebildet sein, auf die ein entsprechender Stecker des Verbindungskabels ausgesteckt wird. Weiterhin ist es denkbar, dass der Steckanschluss als Steckerbuchse ausgebildet ist, in die ein entsprechender Stecker des Kabels eingesteckt werden kann. Über den Steckanschluss kann sowohl eine Stromversorgung des elektrischen Geräts als auch eine Übermittlung von Steuersignalen erfolgen. Das Test- und/oder Installationsmodul ist vorteilhafterweise werkzeuglos anschließbar/montierbar, insbesondere durch einen Steckklemmenanschluss.

Eine Funktionstestauslöseeinrichtung ermöglicht es, einen Funktionstest auf besonders einfache Art und Weise zu starten. Eine manuelle Verbindung einzelner Adern eines Kabels und Beaufschlagen der Ader mit einer Steuerspannung kann entfallen.

Eine vorzugsweise vorgesehene Signalisierungseinrichtung kann als Anzeige dienen, ob ein Test des elektrischen Geräts erfolgreich oder erfolglos durchgeführt wurde. Bei erfolgreichem Test kann das elektrische Gerät an das nächste Gewerk übergeben werden. Anderenfalls kann eine Fehlersuche durchgeführt werden.

Auf besonders einfache Art und Weise kann erkannt werden, ob ein Test erfolgreich war, wenn die Signalisierungseinrichtung als optischer oder akustischer Signalgeber ausgebildet ist. Als optischer Signalgeber kann beispielsweise eine LED vorgesehen sein.

Bei einer besonders bevorzugten Ausführungsform kann vorgesehen sein, dass die Funktionstestauslöseeinrichtung einen oder mehrere Taster umfasst. Beispielsweise können zwei Taster vorgesehen sein, mit denen die Auf/Zu - Funktion sowie ein Reset bewerkstelligt werden können.

In besonders bevorzugter Ausgestaltung der Erfindung kann vorgesehen sein, dass der Steckanschluss zum Anschluss einer lötfreien Quetschverbindung, insbesondere eines Crimp-Steckers, eines insbesondere 8-poligen Telefonkabels geeignet ist. Ein 8-poliges Telefonkabel ist zur Verbindung des erfindungsgemäßen Moduls mit einem elektrischen Gerät geeignet. Dadurch können sowohl Steuersignale als auch die Versorgungsspannung übertragen werden. Die Überprüfung des installierten elektrischen Geräts wird dadurch besonders einfach. Gegebenenfalls kann zu einem späteren Zeitpunkt durch eine Elektrofachkraft ein geeigneter Daueranschluss realisiert werden. Dazu kann gegebenenfalls das Kabel gekürzt werden und mit einem neuen Crimp-Stecker (lötfreie Quetschverbindung) versehen werden. Dies bedeutet, dass das erfindungsgemäß Modul nicht nur zu Testzwecken sondern auch für den Dauerbetrieb mittels des Steckanschlusses verbunden werden kann.

Besonders vorteilhaft ist es, wenn zumindest ein Busanschluss vorgesehen ist. Über einen Busanschluss kann eine Verbindung zur Gebäudesystemtechnik auf einfache Art und Weise hergestellt werden.

Bei einer besonders bevorzugten Ausführungsform kann vorgesehen sein, dass ein oder mehrere austauschbare Busanschlussmodule vorgesehen sind. Das erfindungsgemäße Modul kann somit auf besonders einfache Art und Weise für das in einem Gebäude, in dem das elektrische Gerät angeordnet werden soll, vorhandene Bussystem konfiguriert werden. Beispielsweise können Module für Bussysteme wie EIB/KNX oder LON vorgesehen sein. Die Bustechnik kann auf diese Weise auf einfache Art direkt mit dem elektrischen Gerät installiert werden. Durch diese Maßnahme können entweder weniger fest installierte für einen bestimmten Zweck geeignete bzw. ausgebildete Anschlüsse an dem Test - und/oder Installationsmodul vorgesehen werden oder diese können in paralleler Verdrahtung genutzt werden.

Weiterhin kann vorgesehen sein, dass ein oder mehrere austauschbare Funkempfängermodule vorgesehen sind. Durch diese Maßnahme kann ein Test - und/oder Installationsmodul auf einfache Art und Weise für einen Funkbetrieb ausgerüstet bzw. konfiguriert werden.

Wenn ein oder mehrere - gleiche oder verschiedene -austauschbare Geräteanschlussmodule vorgesehen sind, können mehrere elektrische Geräte an das Test - und/oder Installationsmodul angeschlossen werden.

Vorteilhafterweise können integrierte Dioden zur Entkopplung von Einzel-, Gruppen- und Zentralfunktionen vorgesehen sein, wobei die Dioden an den oder die Steckanschlüsse angeschlossen sind. Eine externe Verdrahtung - wie bisher üblich - kann dadurch entfallen.

Gemäß einer vorteilhaften Ausgestaltung der Erfindung können ein oder mehrere Anschlüsse zum Anschluss an eine Gebäudesystemtechnik vorgesehen sein. Ein solcher Anschluss kann eine direkte Verbindung - ohne Zwischenschaltung eines Systemkopplers - zur Gebäudesystemtechnik ermöglichen.

Wenn das Test- und/oder Installationsmodul kein eigenes Netzteil aufweist, ist es vorteilhaft, wenn ein Anschluss für eine Stromversorgung, insbesondere ein Netzteil vorgesehen ist. Die Ausführung des Test - und/oder Installationsmoduls ohne eigenes Netzteil hat den Vorteil, dass ein solches Test - und/oder Installationsmodul besonders kostengünstig ist. Zum Testen und für die endgültige Installation können unterschiedliche Netzteile zum Einsatz kommen.

Besonders bevorzugt ist es jedoch, wenn ein Netzteil in das Test- und/oder Installationsmodul integriert ist. Dadurch muss keine separate Verbindung zu einem Netzteil hergestellt werden. Außerdem wird die Installation vereinfacht, wenn sämtliche Funktionen für einen Test und für den Dauerbetrieb in das Netzteil integriert sind.

Gemäß einer Weiterbildung kann ein Netzanschluss mit Stecker für Netzsteckdosen und evtl. dazwischen angeordnetem Kabel vormontiert an dem Netzteil vorgesehen sein, wobei der Netzanschluss durch einen Berührungsschutz abgedeckt ist. Dadurch kann der Fensterbauer die Geräte ohne Elektrofachkenntnisse testen, ohne dass ein Verletzungsrisiko durch elektrischen Schlag besteht.

Bei einer Ausführungsform kann ein Niederspannungsversorgungsanschluss vorgesehen sein.

Wenn das Test- und/oder Installationsmodul und eine Antriebseinheit zu einem Gerät zusammengefasst sind, kann dieses Gerät ggfs. direkt am Fenster als vormontiertes Fassadenelement untergebracht werden.

Zusammenfassend ist das erfindungsgemäße Test - und/oder Installationsmodul prinzipiell für alle Geräte der Installationstechnik nutzbar. Besondere Vorteile ergeben sich bei der Installation von Antrieben für Fenster, Türen und Beschattungsanlagen. Das erfindungsgemäße Modul erlaubt eine einfachere Erstinbetriebnahme, beziehungsweise einen Funktionstest durch einen Installateur, beispielsweise einen Fensterbauer. Das Modul kann nach dem Test zur weiteren Funktion des elektrischen Geräts an diesem verbleiben, da das Netzteil zur Stromversorgung des elektrischen Geräts mit Test - sowie weiteren Funktionen ergänzt ist. Das Netzteil kann zur Unterputzmontage geeignet sein. Dadurch erfolgt insgesamt eine einfachere Montage und ein einfacher Umbau der Testinstallation zu einer Dauerinstallation. Die geprüfte Übergabe an einen Elektroinstallateur wird vereinfacht. Vorteilhafterweise erfolgt eine Beschriftung der Anschlüsse, so dass die Montage vereinfacht und Fehlerquellen ausgeschaltet werden.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

Bevorzugte Ausführungsbeispiele der Erfindung sind in der Zeichnung schematisch dargestellt und werden nachfolgend mit Bezug zu den Figuren der Zeichnung näher erläutert. Es zeigt:
- Fig. 1: eine erste Ausführungsform eines Test - und/oder Installationsmoduls ohne integriertes Netzteil;
- Fig. 2: eine zweite Ausführungsform eines Test - und/oder Installationsmoduls mit integriertem Netzteil;
- Fig. 3: eine dritte Ausführungsform eines Test - und/oder Installationsmoduls mit einem Busanschlussmodul;
- Fig. 4: eine vierte Ausführungsform eines Test - und/oder Installationsmoduls mit mehreren Anschlussmodulen.

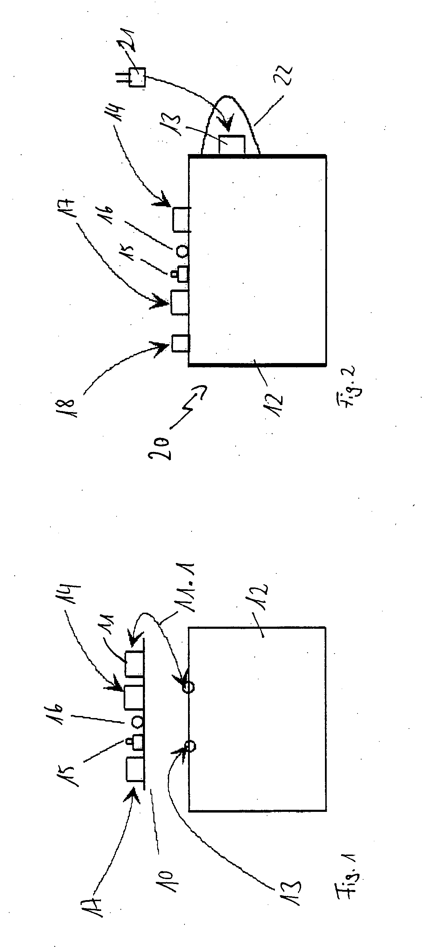

In der Fig. 1 ist ein Test - und/oder Installationsmodul 10 dargestellt. Dieses ist im gezeigten Ausführungsbeispiel als Zusatzbaugruppe ausgebildet, die über einen Anschluss 11 und eine angedeutete Verbindung 11.1 mit einem separaten Netzteil 12 verbunden werden kann. Das Netzteil 12 weist einen Netzanschluss 13 auf.

Das Test - und/oder Installationsmodul 10 weist einen Steckanschluss 14 auf, an den ein Kabel mit einem entsprechenden Stecker angeschlossen werden kann. Das nicht dargestellte Kabel dient der Verbindung zu einem elektrischen Gerät. An den Steckanschluss 14 kann auch eine Tandemkopplung angeschlossen werden, so dass mehrere elektrische Geräte an das Test - und/oder Installationsmodul 10 angeschlossen werden können. Ein Funktionstest eines angeschlossenen elektrischen Geräts kann durch eine als Taster ausgebildete Funktionstestauslöseeinrichtung 15 gestartet werden. Ein erfolgreicher und/oder ein erfolgloser Test werden durch eine als LED ausgebildete Signalisierungseinrichtung 16 angezeigt. Weiterhin ist ein Anschluss 17 zur Verbindung mit einer Gebäudesystemtechnik vorgesehen.

Bei den im Folgenden zu beschreibenden Ausführungsbeispielen werden die gleichen Bezugszeichen wie in Fig. 1 verwendet, sofern gleiche Bauteile bezeichnet werden.

In der Ausführungsform gemäß Fig. 2 ist das Netzteil 12 Bestandteil des Test - und/oder Installationsmoduls 20. Neben dem Anschluss 17 zur Verbindung mit einer Gebäudesystemtechnik ist ein Busanschluss 18 vorgesehen, der alternativ oder zusätzlich zum Anschluss 17 dazu verwendet werden kann, das Test - und/oder Installationsmodul 20 an eine Gebäudesystemtechnik anzuschließen. Über den Busanschluss 18 erfolgt ein direkter Anschluss an ein Bussystem der Gebäudesystemtechnik.

In diesem Ausführungsbeispiel ist an den Netzanschluss 13 ein Netzstecker 21 angeschlossen, so dass beliebige Gewerke das Netzteil 12 an das Spannungsnetz eines Gebäudes anschließen können. Zur endgültigen Installation des Netzteils 12 können der Netzstecker 21 und ggfs. das dazugehörige Kabel wieder entfernt werden. Der Netzanschluss 13 kann dann fest/bleibend mit einem Spannungsversorgungsnetz verbunden werden. Er ist durch einen Berührungsschutz 22 abgedeckt, der z.B. bei der Unterputzmontage durch den Elektroinstallateur entfernt werden kann.

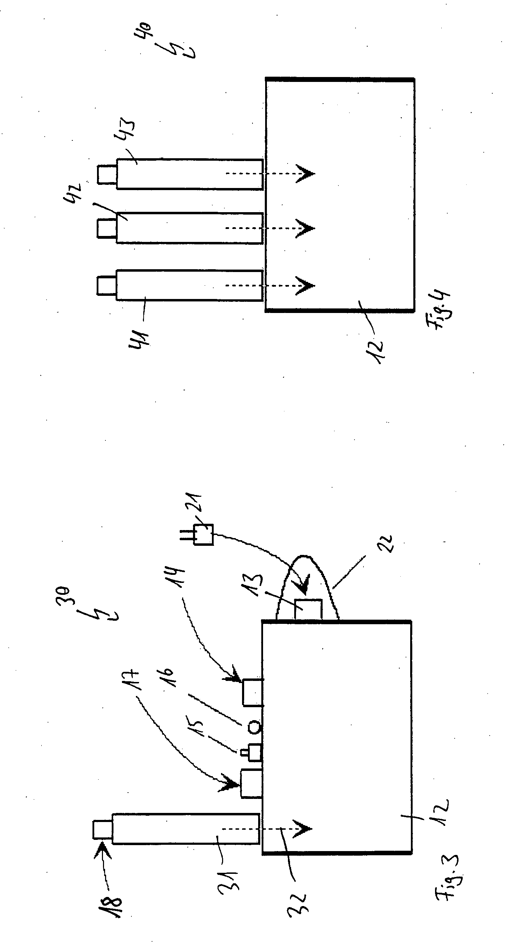

Die Ausführungsform eines Test - und/oder Installationsmodul 30 gemäß Fig. 3 unterscheidet sich von der Ausführungsform gemäß der Fig. 2 dadurch, dass der fest installierte Busanschluss 18 durch ein Busanschlussmodul 31 ersetzt wurde. Das Busanschlussmodul 31 ist austauschbar und kann einfach durch Einstecken in Pfeilrichtung 32 mit dem Test - und/oder Installationsmodul 30 verbunden werden. Somit kann das Test - und/oder Installationsmodul 30 für die Verwendung in unterschiedlichen Gebäuden mit unterschiedlichen Bussystemen konfiguriert werden. Je nach vorhandenem Bussystem wird ein Busanschlussmodul 31 geeignet gewählt.

Bei dem Test - und/oder Installationsmodul 40 gemäß Fig. 4 sind mehrere Geräteanschlussmodule 41 - 43 vorgesehen. Alle diese Geräteanschlussmodule 41 - 43 sind an das Netzteil 12 angeschlossen. Dadurch kann ein und dasselbe Netzteil 12 zur Stromversorgung unterschiedlicher elektrischer Geräte verwendet werden. Die Funktionseinheiten 14,15, 16,17 können jeweils an den Geräteanschlussmodulen 41 - 43 ausgebildet sein, so dass jedes angeschlossene Gerät individuell getestet werden kann.

## Patentansprüche

1. Test- und/oder Installationsmodul (10, 20, 30,40) für in oder an einem Gebäude zu montierende elektrische Geräte, **dadurch gekennzeichnet, dass** es zumindest einen Steckanschluss (17) zum Anschluss einer Verbindungsleitung zu dem elektrischen Gerät und eine Funktionstestauslöseeinrichtung (15) aufweist.

2. Test- und/oder Installationsmodul nach Anspruch 1, **dadurch gekennzeichnet, dass** eine Signalisierungseinrichtung (16) vorgesehen ist

3. Test- und/oder Installationsmodul nach Anspruch 2, **dadurch gekennzeichnet, dass** die Signalisierungseinrichtung (16) als optischer oder akustischer Signalgeber ausgebildet ist.

4. Test- und/oder Installationsmodul nach einem der vorhergehenden Ansprüche, **dadurch gekennzeichnet, dass** die Funktionstestauslöseeinrichtung (15) einen oder mehrere Taster umfasst.

5. Test- und/oder Installationsmodul nach einem der vorhergehenden Ansprüche, **dadurch gekennzeichnet, dass** der Steckanschluss (17) zum Anschluss einer lötfreien Quetschverbindung (Crimp-Stecker) eines insbesondere 8-poligen Telefonkabels geeignet ist.

6. Test- und/oder Installationsmodul nach einem der vorhergehenden Ansprüche, **dadurch gekennzeichnet, dass** zumindest ein Busanschluss (18) vorgesehen ist.

7. Test- und/oder Installationsmodul nach einem der vorhergehenden Ansprüche, **dadurch gekennzeichnet, dass** ein oder mehrere austauschbare Busanschlussmodule (31) vorgesehen sind.

8. Test- und/oder Installationsmodul nach einem der vorhergehenden Ansprüche, **dadurch gekennzeichnet, dass** ein oder mehrere austauschbare Funkempfängermodule vorgesehen sind.

9. Test- und/oder Installationsmodul nach einem der vorhergehenden Ansprüche, **dadurch gekennzeichnet, dass** ein oder mehrere austauschbare Geräteanschlussmodule (41 - 43) vorgesehen sind.

10. Test- und/oder Installationsmodul nach einem der vorhergehenden Ansprüche, **dadurch gekennzeichnet, dass** integrierte Dioden zur Entkopplung von Einzel-, Gruppen- und Zentralfunktionen vorgesehen sind, wobei die Dioden an den oder die Steckanschlüsse (14) angeschlossen sind.

11. Test- und/oder Installationsmodul nach einem der vorhergehenden Ansprüche, **dadurch gekennzeichnet, dass** ein oder mehrere Anschlüsse (17) zum Anschluss an eine Gebäudesystemtechnik vorgesehen sind.

12. Test- und/oder Installationsmodul nach einem der vorhergehenden Ansprüche, **dadurch gekennzeichnet, dass** ein Anschluss (11) für eine Stromversorgung, insbesondere ein Netzteil (12), vorgesehen ist.

13. Test- und/oder Installationsmodul nach einem der vorhergehenden Ansprüche 1 bis 11, **dadurch gekennzeichnet, dass** ein Netzteil (11) in das Test- und/oder Installationsmodul (10, 20, 30, 40) integriert ist.

14. Test- und/oder Installationsmodul nach Anspruch 12, **dadurch gekennzeichnet, dass** ein Netzanschluss (13) vorgesehen ist, der durch einen Berührungsschutz (22) abgedeckt ist.

15. Test- und/oder Installationsmodul nach einem der vorhergehenden Ansprüche, **dadurch gekennzeichnet, dass** ein Niederspannungsversorgungsanschluss vorgesehen ist.

16. Test- und/oder Installationsmodul nach einem der vorhergehenden Ansprüche, **dadurch gekennzeichnet, dass** das Test- und/oder Installationsmodul und eine Antriebseinheit zu einem Gerät zusammengefasst sind.
